# EUROPEAN PATENT SPECIFICATION

(11) **EP 2 425 036 B1**
(45) Date of publication and mention of the grant of the patent: **08.11.2017**
(21) Application number: 10717605.9
(22) Date of filing: 23.04.2010
(51) Int. Cl.: C23C 14/35, C23C 14/50

(54) **REACTIVE SPUTTERING WITH MULTIPLE SPUTTER SOURCES**
REAKTIVES SPUTTERN MIT MEHREREN SPUTTERQUELLEN
PULVÉRISATION CATHODIQUE RÉACTIVE AVEC DE MULTIPLES SOURCES DE PULVÉRISATION CATHODIQUE

(30) Priority: 27.04.2009 US 172828 P
(43) Date of publication of application: 07.03.2012
(73) Proprietor: Oerlikon Advanced Technologies AG, 9496 Balzers (LI)
(72) Inventor: DUBS, Martin, 7304 Maienfeld (CH); RUHM, Kurt, 9495 Triesen (LI); ROHRMANN, Hartmut, 69198 Schriesheim (DE)
(74) Representative: Troesch Scheidegger Werner AG
(86) International application number: PCT/EP2010/055453
(87) International publication number: WO 2010/125002

(56) References cited:
- EP-A1- 0 450 163
- WO-A1-2009/052874
- US-A- 4 595 482
- US-A- 6 096 174

## Description

### Technical Field

The invention relates to the field of reactive sputter-coating of substrates, more particularly to reactive magnetron sputter coating. It relates to methods and apparatuses according to the opening clauses of the claims.

### Background of the Invention

The invention can comprise or find an application in the manufacture of waveguides, more particular optical waveguides.

Starting with this example, the underlying problems of reactive sputter coating shall be discussed along with known solutions for these problems.

A waveguide is used to conduct light in tight spaces. It works similar to an optical fiber. Light is conducted in a medium of high refractive index surrounded by a medium of lower refractive index. Total reflection prevents the light from exiting the high index medium. The same principle applies to a thin film of high refractive index, sandwiched between layers of lower refractive index. Optical thin films are particularly suited to applications in optoelectronics, where they can be integrated into the manufacturing of semiconductor chips. A special requirement for thin film waveguides is minimal absorption and scattering of the light. A typical thin film waveguide consists of a Ta₂O₅ film sandwiched between SiO₂ or Al₂O₃ cladding layers. The alumina film also gives good mechanical protection to the waveguide.

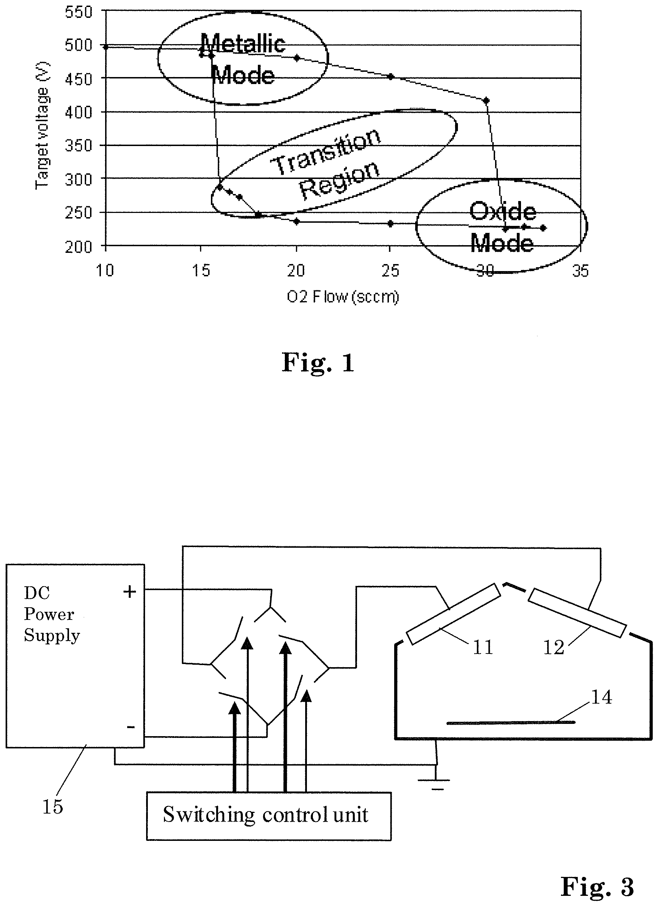

As many other dielectrics, alumina can be deposited by sputtering a metallic aluminum target in the presence of oxygen. In the simplest way, a pulsed DC (direct current) power supply is set at a selected power level. Depending on the oxygen flow the resulting reactive process will either tilt over to the "metallic" or the "oxide" mode. This behavior is described by the well-known reactive sputter hysteresis curve where the target voltage is recorded vs. the oxygen flow with constant sputter power. Fig. 1 shows such a reactive sputter hysteresis curve.

When coating substrates (e.g., glass substrates) with a metallic coating like aluminum, sputtering devices are frequently used which comprise an electrode with a target. The metallic target is sputtered due to the electrically charged particles (Ar ions from Ar working gas) impinging on it. In the process, the sputtered particles, eventually after a reaction with a gas like oxygen or nitrogen, are deposited on the substrate. A particular arrangement of electrode, target and magnets in which the target is penetrated by a magnetic field is referred to as a magnetron. If the material particles sputtered from a target react with a gas before their deposition on said substrate, the process is referred to as reactive sputtering. If, for example, SiO₂ is to be vapor-deposited onto a substrate, Si atoms are sputtered from a Si target, which again react with oxygen introduced into the process chamber. The oxygen, introduced at a constant electrical power affects the discharge voltage at the cathode(s) of the process chamber. If the discharge voltage is plotted over the O₂ flow at constant electrical power, a curve with a hysteresis results (cf. Fig. 1).

With increasing oxygen flow (arrow A in Fig. 1) the target or discharge voltage initially decreases slightly and subsequently drops steeply to a low value, together with a sharp drop of sputter rate and increase of oxygen partial pressure in the process chamber, since at low sputter rate, less oxygen is needed to oxidize the deposited film (arrow B in Fig. 1). Continuing from this value, the discharge voltage subsequently decreases only negligibly with increasing oxygen flow.

If now the oxygen flow is reduced (arrow C in Fig. 1), the target voltage will only slowly increase. However, the discharge voltage will increase steeply (arrow D in Fig. 1) at a specific, lower oxygen flow. Since those oxygen flows, at which the voltage (steeply) decreases and (steeply) increases, respectively, are not identical, a hysteresis results.

Setting a stable operating point is difficult due to this behaviour, since only slight changes of the oxygen flow, and/or the electrical power supplied can suddenly result in a "jump" of the discharge voltage.

The hysteresis occurs, because with increasing oxygen flow the target gets partially covered with oxide which has a lower sputter rate. At low oxygen flows (arrow A in Fig. 1), most of the oxygen is used up to form alumina films on the substrate and shields. Above a certain threshold, the sputter rate drops, leaving more oxygen in the process chamber, which leads to more oxide on the target until the target is fully covered with oxide at a very low sputter rate (arrow B in Fig. 1). This is called the oxide mode.

Reducing the oxygen flow still leaves (i.e. lets persist) a high oxygen partial pressure, until the oxide is removed from the target (arrow C in Fig. 1). At that point, the sputter rate increases, uses up the remaining oxygen, and the target is again in the metallic mode (arrow D in Fig. 1).

By far most applications require pure dielectric properties of alumina; e.g., low optical absorption and high dielectric strength. This cannot be achieved in the metallic region where the target surface is still metallic and only some degree of oxidation of the growing film occurs on the substrate. Selecting a working point in the oxide mode region on the other hand will result in absorption free films. However, since the target surface is fully oxidized in this mode, the resulting deposition rate is very low, and the composition of the growing film cannot be tuned.

For the deposition of fully dielectric films with the possibility of composition control and high deposition rate, operation in the transition region between metallic and oxide mode is necessary which requires an active feedback mechanism. It is possible to select a sputter voltage control for the transition mode sputtering for aluminium oxide, and the inventors have carried out corresponding experiments. In comparison to other proven methods like optical emission and partial pressure control, the usage of the power supply as a constant voltage source means (using appropriate power supplies) just a change of the operation mode of the device.

By stabilizing the voltage, the region between the jumps (transition region) can be reached in a reproducible manner without running the process off into either the metallic mode or the oxide mode.

Further below in section "Summary of the Invention", further problems of reactive sputter coating shall be discussed, along with related documents of the state of the art.

### Summary of the Invention

Therefore, one object of the invention is to create apparatuses and methods that do not have the disadvantages mentioned above. An apparatus for coating a substrate by reactive sputtering shall be provided, which enables an improved way of manufacturing sputter-coated substrates by reactive sputter coating. In addition, the respective method shall be provided.

Another object of the invention is to provide a way to achieve a homogeneous deposition in reactive sputter coating.

Another object of the invention is to provide a way to achieve a uniform thickness distribution of a coating produced by reactive sputter coating.

Another object of the invention is to provide a way of reactive sputter coating which allows to tune the coating composition in a rather well-defined way.

Another object of the invention is to provide a way of reactive sputter coating which rather simply allows to have rather stable deposition conditions, in particular to have a rather constant deposition rate.

Another object of the invention is to provide a way of reactive sputter coating which rather simply allows to achieve particularly reproducible properties of the coating.

Another object of the invention is to provide a way of reactive sputter coating which rather simply allows to achieve particularly homogeneous properties of the coating.

Further objects emerge from the description and embodiments below.

At least one of these objects is at least partially achieved by apparatuses and methods according to the patent claims.

The apparatus for coating a substrate by reactive sputtering comprises an axis, at least two targets in an arrangement symmetrically to said axis and a power supply connected to said targets, wherein said targets are alternatively operable as cathode and anode.

This way, the "disappearing anode" problem is handled, and at the same time, a good coating uniformity can be achieved.

In one embodiment, said apparatus is a vacuum deposition system.

In one embodiment optionally referring to the before-addressed embodiment, said targets are alternatively operable as cathode and anode using said power supply.

In one embodiment which may be combined with one or more of the before-addressed embodiments, said power supply is connected to said targets in such a way that said targets are alternatively operable as cathode and anode.

In one embodiment which may be combined with one or more of the before-addressed embodiments, said power supply is structured and configured for operating said targets alternatively as cathode and anode.

In one embodiment which may be combined with one or more of the before-addressed embodiments, said targets are alternatively operated as cathode and anode
In one embodiment which may be combined with one or more of the before-addressed embodiments, said power supply is a DC power supply.

In one embodiment which may be combined with one or more of the before-addressed embodiments, the apparatus comprises means for rotating said substrate around said axis, in particular means for rotating said substrate around said axis during coating. This greatly enhances the achievable homogeneity and thickness uniformity of the coating.

In one embodiment which may be combined with one or more of the before-addressed embodiments, the apparatus comprises a substrate carrier for carrying said substrate and means for rotating said substrate carrier around said axis. This is a way to make the substrate rotatable.

This embodiment is of particular importance, since the possibility to rotate the substrate during sputtering allows to manufacture particularly good coatings, in particular as to the achievable uniformity.

In one embodiment which may be combined with one or more of the before-addressed embodiments, said arrangement symmetrically to said axis comprises that said targets are arranged such that their respective target centres are arranged on a circle around said axis.

In one embodiment which may be combined with one or more of the before-addressed embodiments, said arrangement symmetrically to said axis means that said targets are arranged symmetrically to said axis with their respective target centres arranged on a circle around said axis.

In one embodiment which may be combined with one or more of the before-addressed embodiments, said arrangement symmetrically to said axis comprises or, in particular, means, that said targets are arranged on a defined radius around said axis.

In one embodiment which may be combined with one or more of the before-addressed embodiments, said apparatus is an apparatus for coating a substrate, in particular for coating a single substrate, with a dielectric coating, in particular an apparatus for reactive magnetron sputtering of metal oxides with pulsed DC sputtering.

In one embodiment which may be combined with one or more of the before-addressed embodiments, said targets are metallic targets.

In one embodiment which may be combined with one or more of the before-addressed embodiments, said apparatus is a single substrate sputtering system.

In one embodiment which may be combined with one or more of the before-addressed embodiments, the apparatus comprises high voltage switching elements, wherein said a power supply is connected to said targets via said high voltage switching elements for allowing said targets to operate alternatively as cathode and anode. This is an elegant, simple and cost-effective way of providing the targets with the appropriate target voltages.

In one embodiment which may be combined with one or more of the before-addressed embodiments, said power supply is a single power supply connected to said targets, in particular a single DC power supply. This is an elegant, simple and cost-effective way of providing the targets with the appropriate target voltages; in particular when combining it with the before-addressed high voltage switching elements.

In one embodiment which may be combined with one or more of the before-addressed embodiments, said targets are arranged such that a plane defined by an unsputtered front plane of the respective target is angled with respect to a plane perpendicular to said axis, in particular angled by an angle between 2° and 20°.

In one embodiment of the method which may be combined with one or more of the before-addressed embodiments, said targets are circular targets.

In one example not forming part of the present invention, said targets are arranged concentrically, with an innermost circular target surrounded by at least one ring-shaped outer target, in particular wherein said outer target has a similar sputtering area. This way, a good uniformity can be achieved, even with a stationary (non-rotating) substrate. When each of said outer targets has approximately the same sputtered area as said innermost target, the electrode area stays substantially the same during the alternating cathode-anode operation, which contributes to electric stability of the system.

In one example not forming part of the present invention, said at least one outer target describes a rotationally-symmetric portion of a surface of a cone, wherein a surface normal of an unsputtered front plane of said at least one outer target is angled with respect to said axis. This results in an improved target utilization.

The method for manufacturing a coated substrate by coating a substrate by reactive sputtering in an apparatus comprising an axis comprises the steps of
a) providing a substrate to be coated;
b) providing at least two targets in an arrangement symmetrically to said axis;
c) alternatively operating said targets as cathode and anode during coating.

This way, the "disappearing anode" problem can be solved, and at the same time, a good coating uniformity can be achieved.

In one embodiment of the method, said arrangement symmetrically to said axis comprises that said targets are arranged with their respective target centres on a defined radius around said axis.

In one embodiment of the method which may be combined with one or more of the before-addressed embodiments, the method comprises the step of
d) rotating said substrate around said axis during said coating;
more particularly wherein step d) is carried out during step c). This strongly enhances the achievable coating uniformity. Accordingly, his embodiment is of particular importance, since the possibility to rotate the substrate during sputtering allows to manufacture particularly good coatings, in particular as to the achievable uniformity.

In one embodiment of the method which may be combined with one or more of the before-addressed embodiments, the method comprises the step of coating said substrate, in particular a single substrate, with a dielectric coating; in particular coating said substrate, in particular a single substrate, by reactive magnetron sputtering of metal oxide with pulsed DC sputtering.

In one embodiment of the method which may be combined with one or more of the before-addressed embodiments, step c) comprises using high voltage switching elements connected to said targets and to a power supply for alternatively operating said targets as cathode and anode during coating, in particular wherein said power supply is a single power supply, more particularly a single DC power supply.

In one embodiment of the method which may be combined with one or more of the before-addressed embodiments, said method comprises operating said power supply in constant voltage mode. This allows to achieve rather stable process conditions.

In one embodiment of the method which may be combined with one or more of the before-addressed embodiments, said coating is accomplished by constant voltage sputtering.This way, a stable operation is readily achievable. If, during the sputtering, the voltage applied to a specific target is unchanged, a good process stability can be achieved. Therein, note that for each target, sputtering takes place only when the target is operated as a cathode, and no sputtering takes place when the target is operated as an anode.

In one embodiment of the method which may be combined with one or more of the before-addressed embodiments, step c) comprises applying a target voltage to said targets, and the method comprises the step of adjusting the pulse width of said target voltage for fine-tuning the thickness of the manufactured coating in the inner and outer region of the substrate. The pulse width determines the ratio of the time during which the target is operated as a cathode (i.e. the time during which sputtering of that target can be accomplished) and the time during which the target is operated as an anode (i.e. the time during which no sputtering of that target can be accomplished). Usually, during the time a target is operated as an anode, one or more other targets are operated as cathodes. Adjusting the pulse width can be a relatively simple way for achieving optimum uniformity (of the manufactured coating).

In one embodiment of the method which may be combined with one or more of the before-addressed embodiments, said targets are alternatively operated as cathode and anode at a frequency of 40 kHz. A sufficiently high switching frequency like said 40 kHz avoids arcing at the targets.

In one embodiment of the method which may be combined with one or more of the before-addressed embodiments, said targets are arranged such that a plane defined by an unsputtered front plane of the respective target is angled with respect to a plane perpendicular to said axis, in particular angled by an angle between 2° and 20°.

In one embodiment of the method which may be combined with one or more of the before-addressed embodiments, said targets are circular targets.

In one embodiment of the method which may be combined with one or more of the before-addressed embodiments, said targets are of approximately the same size and shape, and they are arranged approximately evenly distributed with their respective center on a circle, and wherein each of said targets are substantially equally arranged with respect to said axis.

In one illustrative example not forming part of the present invention, said targets are arranged concentrically, with an innermost circular target surrounded by at least one ring-shaped outer target, in particular wherein said at least one outer target has a similar sputtered area.

In one embodiment of the method which may be combined with one or more of the before-addressed embodiments, a coating manufactured by said method comprises at least one of the group consisting of
- a low absorption film;
- an optical dielectric filter;
- a wave guide;
- an optical thin film;
- an Al₂O₃ film;
- a Ta₂O₅ film, in particular aTa₂O₅ film sandwiched between SiO₂ or Al₂O₃ cladding layers;
- a film of mixed oxides, in particular from metallic targets of different composition.

The invention comprises methods with features of corresponding apparatuses according to the invention, and vice versa.

The advantages of the methods basically correspond to the advantages of corresponding apparatuses and vice versa.

Viewed from a particular point of view, which will be discussed now, the invention relates to reactive magnetron sputtering of metal oxides with pulsed DC sputtering in order to achieve a high sputter rate with stable film composition and good uniformity in a single substrate sputtering system. The goal is to produce low absorption films, e.g., of Al₂O₃ for applications such as optical dielectric filters in general or wave guides in particular. It uses technology known from large area coating technology such as the dual magnetron and combines it with multisource deposition on rotating substrates, resulting in very good uniformity and stoichiometry. It also avoids the problem of the disappearing anode in single cathode sputtering, which is mostly used for single substrate sputtering, leading to a reproducible and stable process.

From said particular point of view, the invention has a background in the following:
For reactive DC sputtering from a metallic target, a reactive gas is added to the sputter (working) gas (Argon or another noble gas). The addition of a reactive gas (like oxygen or nitrogen) has the tendency to cover essentially all interior surfaces of the sputter chamber with a dielectric film thus forming an insulating film. This again reduces the effective area of the counter electrode. This phenomenon is called "disappearing anode" and leads to a drift of the voltage range for stable operation in constant voltage mode and therefore also to a drift of sputter rate and film properties. At the same time, some deposition of dielectric material on the target area occurs ("target poisoning"). These layers act as capacitive coatings in the overall electrical circuit. This leads to arcing and unstable operation for a wide range of reactive gas flows. Arcing at the oxidized target can be overcome by pulsing the DC voltage at the target as described in US 5,948,224 and US 5,427,669. These methods, however, do not solve the problem of the disappearing anode.

In order to solve this problem, a dual magnetron has been proposed, with the two targets operated with an AC voltage, therefore both targets are operated alternatively as cathode and anode, as described in US 5,169,509 and also in US 6,096,174. The buildup of oxide on the anode is removed during the time at which the target is sputtered as cathode. The same goal can be achieved with two or more sputter sources and a switching power supply as described in US 5,917,286.

These problems in reactive sputtering are encountered also in the semiconductor industry, where single wafers should be coated uniformly with highly insulating dielectrics and for optical coatings where films with low absorption at visible wavelengths down into the UV are required.

Existing single cathode sputtering solutions with planar magnetrons and reactive pulsed DC sputtering suffer from the problem of the "disappearing anode", low sputter rates due to the coverage of the target with a thin oxide layer and a pronounced unstability of the process with a large hysteresis between the metallic mode with high sputter rate and the oxide mode with very low sputter rate.

Without a sophisticated process control it is difficult to achieve good process stability of sputter rate and film composition and related film properties such as refractive index and absorption coefficient.

It has been suggested to sputter at constant voltage (R. Mac Mahon et. al. in J. Vac. Sci. Technol. 20 (1982), p 376), which helps to some extent with additional gas flow control but does not remove the problem of changing conditions at the anode. Prior Art therefore proposes an adjustment of voltage or power before the actual sputtering, which makes it difficult to run the process in a reproducible automatic manner.

With a stationary cathode-to-substrate arrangement an erosion profile good for thickness uniformity on the substrate conflicts with an erosion profile which minimizes partial deposition of oxide layers which lead to arcing at the borders between the oxidized target layer and the sputtered metallic target area.

In a first aspect of the invention as viewed from said particular point of view, the solution of these problems is based on a combination at least two of the following elements:
- The problem of the disappearing anode is solved with at least two sputter sources (targets), alternately operated as cathode and anode. A single power supply is connected to both sputter sources via high voltage switching elements thus allowing them to operate alternatively as cathode and anode. Arcing of the target voltage is avoided by sufficiently high switching frequency.
- Good uniformity is achieved by rotating the substrate to be treated and having an arrangement of the cathodes symmetrically to the rotation axis. Good uniformity is achieved by a suitable choice of distance between target centre and rotation axis, of distance between target centre and substrate surface and of angle between target surface and substrate surface or rotation axis.
- An angled arrangement of cathodes towards the substrate has the additional advantage of high efficiency of the transfer of sputtered material to the substrate to be coated.
- A clean target surface is achieved on a circular target with a rotating magnet system designed for full erosion of the target so that no oxide will build up. This is possible because uniformity can be controlled independently of the erosion profile by the geometry of the sputter source arrangement.
- By operating the targets at high power density (due to the smaller total target area in comparison with a single target considerably larger than substrate size), oxidation of the target is further reduced with a reactive gas partial pressure sufficient to fully oxidize the substrate or deposit a reactive sputter layer.
- The hysteresis inherent to reactive sputtering of oxides is avoided by large pump cross sections and the use of constant voltage sputtering.
- The system can further be optimized by using more than two cathodes in a circular arrangement for higher sputter rates. The maximum sputter rate is normally limited by the temperature of the targets, determined by the heat conductivity and specific power per cathode area. In this case the switching has to be modified so that one sputter source is operated as cathode, the others as anode. This helps preventing imbalances in the oxidation state and sputter rate between different cathodes.
- A symmetric gas inlet on the substrate side for the reactive gas helps achieving stoichiometric films with low absorption at high sputter rate. It also helps in establishing similar sputter conditions for all targets.
- In order to achieve stable conditions from the beginning of the deposition, a good vacuum has to be maintained at all times, preferably by entering the substrates through a load lock and/or a transport chamber. Alternatively or in addition, a shutter may be inserted between targets and substrate and a stable operation may be achieved by sputtering behind the shutter. As soon as sputter power and target oxidation have stabilized, the shutter may be opened and the film may be deposited on the substrate. A good vacuum may also be achieved by use of Meissner traps in the sputter chamber or transport chamber.

In a further illustrative example not forming part of the present invention as viewed from said particular point of view, an alternative to the above described arrangement (first aspect), namely the following arrangement is proposed:
- Instead of arranging the targets on a circle and rotating the substrate, the targets are arranged concentrically with an innermost circular target surrounded by at least one ring-shaped outer target of similar sputtered area.
- A single power supply is switched by high voltage switching elements. Arcing of the target voltage is avoided by a sufficiently high switching frequency.
- Good process stability is achieved by choosing a geometry (target substrate distance, target radii) to give an approximate good uniformity with equal power density on all targets. To achieve optimum uniformity, the pulse width on the different targets can be adjusted to fine tune the film thickness in the inner and outer region of the substrate.
- An advantage of this arrangement is that no substrate rotation is needed, although it may be helpful to reduce variations of thickness caused by uneven reactive gas supply caused by asymmetric gas inlet or pump geometry.
- A clean target surface is achieved on a circular target with a rotating magnet system designed for full erosion of the targets so that no oxide will build up. This is possible because uniformity can be controlled independently of the erosion profile by the geometry of the sputter source arrangement and the pulse width.
- Other aspects of the first arrangement are also valid for this arrangement, such as high power density by using relatively small targets, use of constant voltage sputtering, symmetric gas inlet and use of more than two cathodes for better uniformity control.
- The concentric targets may be arranged in a plane parallel to the substrate. For better material utilization the outer targets may be cone shaped (describing a rotationally-symmetric portion of a cone surface), with the target normal facing the towards the substrate centre.
- The rotating magnet system can be mounted on a single rotating platform to simplify the mechanical setup as described in US 4,622,121.

It is noted that the use of several cathodes leads to the possibility of reactive sputtering of mixed oxides from metallic targets of different composition. In this case, hoewever, simple constant voltage sputtering may not work (or not work satisfactorily) and would (preferably) have to be combined with some other process control such as partial pressure regulation and by regulating the energy per pulse for each material by adjusting power or pulse width.

Further embodiments and advantages emerge from the dependent claims and the figures.

### Brief Description of the Drawings

Below, the invention is described in more detail by means of examples and the included drawings. The figures show:
- Fig. 1: a reactive sputter hysteresis curve (discharge voltage vs. O₂ flow at constant electrical power);
- Fig. 2: a cross-sectional view of a vacuum deposition system;
- Fig. 3: a block-diagrammatical illustration of an apparatus, emphasizing aspects related to the generation of the target voltages;
- Fig. 4: an illustration of results of pre-experiments with a DC power supply, at constant power;
- Fig. 5: an illustration of results of constant voltage sputtering;
- Fig. 6: film properties (refractive index n as function of wavelength) of experimental samples;
- Fig. 7: film properties (k as function of wavelength) of experimental samples.

The described embodiments are meant as examples and shall not confine the invention.

### Detailed Description of the Invention

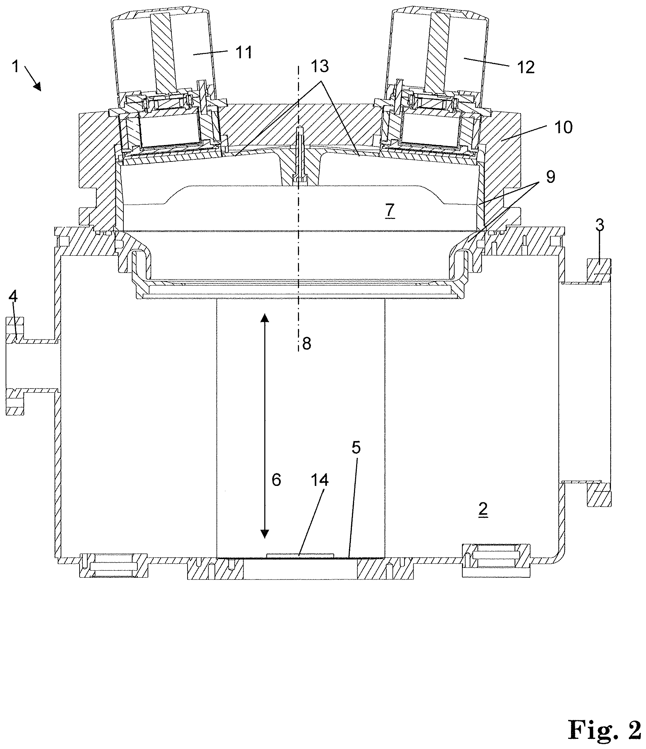

Fig. 2 shows a cross-sectional view of a vacuum deposition system 1. The vacuum deposition system 1 ("Multisource") comprises a load/unload enclosure 2 with ports 3 and 4 for pumps (not shown) and load/unload means (omitted), e.g. a wafer handler or substrate robot. A substrate carrier 5 is shaped to accept substrates 14 like wafers (silicon, glass or alike) of round or rectangular or square shape. The substrate carrier 5 may be designed to be movable by means of a lifting mechanism, as indicated by arrows 6, to accept or deliver substrates in a lower position and to clamp substrates 14 in an elevated position, as indicated in Figure 2, thus exposing the substrate to processing chamber 7. The substrate carrier 5 may exhibit mechanical clamping means like springs or weight rings or may be designed as an electrostatic chuck. The substrate carrier 5 may, in a specific embodiment, provide for means allowing for rotating the substrate. This can be achieved by a motor operatively acting upon the substrate carrier thus rotating it around a central axis 8. Advantageously, this motor and the lifting mechanism are built as a unit.

The processing chamber 7 is established essentially by a bottom part - substrate carrier 5, sidewall elements 9 and an upper part or cover 10. In the upper part 10, there are arranged 3 or more sputter cathodes 11, 12... (Fig. 2 shows two in cross-section). The inner surface 13 of upper part 10 exhibits essentially the shape of a flat cone with a rotational symmetry axis 8, equal for all targets and referring to the respective target center. The cathodes 11, 12... are arranged on a defined radius around symmetry axis 8. Gas inlets and electrical wiring have been omitted in Fig. 2.

One exemplary substrate size is an 8" wafer (about 20 cm), but the substrate carrier 5 (and the whole system) may be construed to accommodate 30 cm wafer or glass substrates. The system may be designed to match smaller substrates like 10 cm substrates (4") - the man skilled in the art will adopt the size of system according to the principles given herein.

For 200 mm substrate size, one preferably selects the target-substrate distance to be between 100 and 170 mm. The diameter of the targets used in cathodes 11, 12 is advantageously chosen to be 150 mm, but may be between 70 and 160 mm. The shortest distance between centre of target (at cathode 11 and 12) and symmetry axis 8 (target eccentricity) is typically somewhat larger than the substrate radius and may be varied together with target substrate distance and inclination angle to give optimum uniformity or optimum deposition efficiency. The optimum geometry was calculated by computer simulation and gives good agreement with measured uniformity. The target angle between a plane perpendicular to symmetry axis 8 and a plane defined by the unsputtered target front plane is chosen to be 15°, but may be adjusted to between 2 and 20°.

In one embodiment with three cathodes having a target-diameter of 150 mm, target eccentricity of 140 mm and a target substrate distance of 130 mm and a target angle of 15°, a uniformity of +-1% has been achieved.

Fig. 3 shows a block-diagrammatical illustration of an apparatus, emphasizing aspects related to the generation of the target voltages, more particularly showing a sputter power supply with high voltage switching elements. A regular DC power supply 15 with the switching scheme as indicated in Fig. 3 can be used. The sputtering has been carried out with two A1 targets switched at 40 kHz. A sputter rate with two A1 targets switched of 1.3 nm/sec/kW has been achieved.

Figure 3 shows a DC power supply 15, wherein with the aid of four switches, two targets 11,12 can be switched to be a cathode or anode or solely cathodes or anodes.

This scheme can easily be extended to more than two targets, especially four targets can be switched in sequence, with one or more of the remaining targets switched as anodes. Running the four targets at high peak power with low duty cycle is an advantage for good target erosion. A large anode area will also be an advantage. In order to achieve process stability, the power supply would run in constant voltage mode.

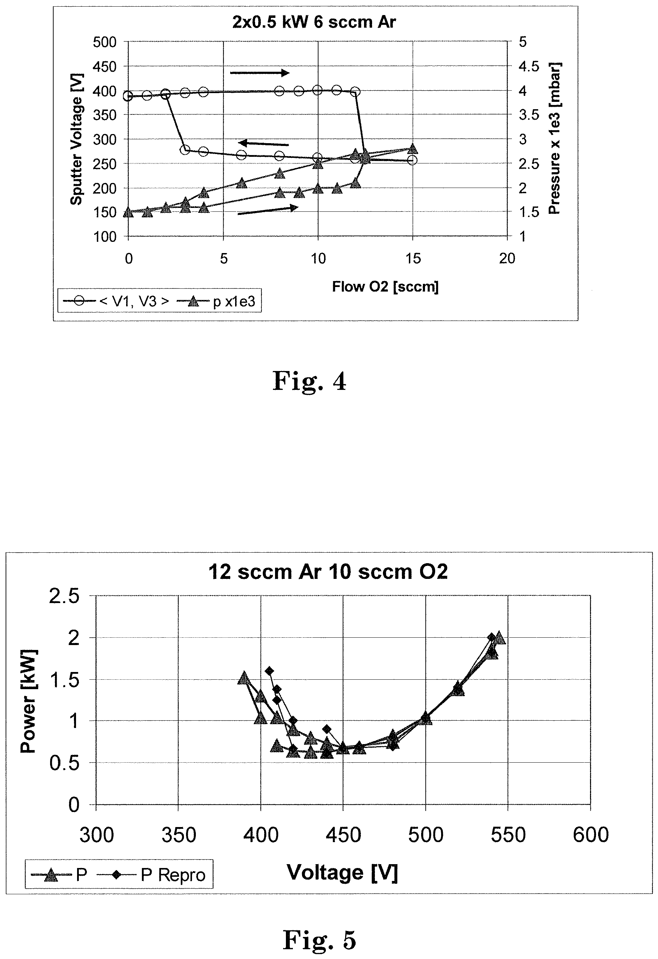

Fig. 4 shows an illustration of results of pre-experiments with a DC power supply, at constant power, more particularly a graph of voltage and pressure vs. reactive gas flow. These experiments were carried out with multisource quattro on DVD Sprinter (a commercially available system). The sputter rate for A1 was 1.5 nm/sec/kW (DC). DC sputtering in oxide mode has been carried out at constant power of 0.08 nm/sec/kW.

Fig. 5 shows an illustration of results of constant voltage sputtering. The constant voltage sputtering has been limited to < 2 kW total power. At 420 V and 12 sccm O₂ flow, high rate oxide mode was present. Stable operation has beend achieved. A sputter rate of 0.6 nm/sec required a power of 0.8 - 0.9 kW. The voltage power relation needed settling time (with a time constant of approx. 10 min).

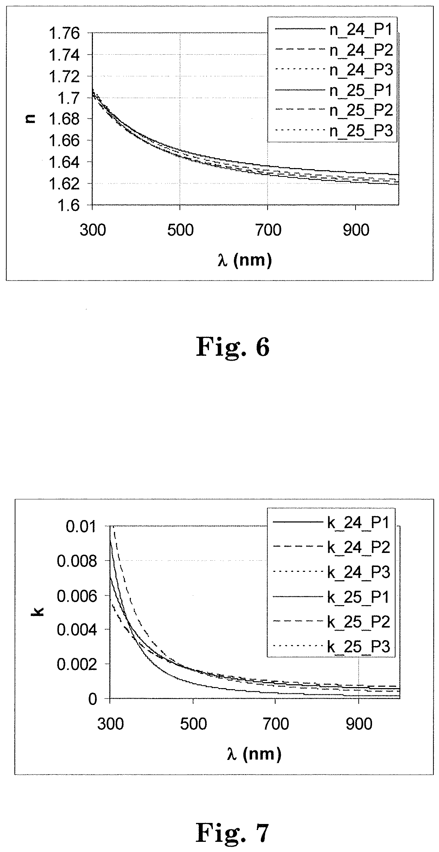

Fig. 6 shows film properties (refractive index n as function of wavelength) of experimental samples, more particularly of samples prepared in the way discussed in conjunction with Figs. 2 to 5. Fig. 7 shows film properties (k as function of wavelength) of the same experimental samples. The specific sputter is in the range of predicted values, in particular 0.8nm/sec/kW for the oxide. A stable operation up to 1kW has been achieved. A uniformity of at least +/- 3.2 % on 120 mm diameter was achieved. Refractive index n amounted to n = 1.63 - 1.65, and k to k < 1e-3 at 633 nm, wherein the latter can be optimized with the process (e.g., by adjusting the pump time etc.).

## Claims

1. An apparatus (1) for coating a substrate (14) by reactive sputtering, comprising an axis (8), at least two targets (11, 12) in an arrangement symmetrically to said axis (8), a substrate carrier (5) for carrying said substrate (14) and a power supply (15) connected to said targets (11,12), wherein said targets are alternatively operable as cathode and anode, **characterised in that** the apparatus (1) further comprises means for rotating said substrate carrier (5) around said axis (8), and further **characterised in that** said targets (11, 12) are arranged such that a plane defined by an unsputtered front plane of the respective target (11; 12) is angled between 2° and 20° with respect to a plane perpendicular to said axis (8).

2. The apparatus according to claim 1, wherein said arrangement symmetrically to said axis (8) comprises that said targets (11, 12) are arranged such that their respective target centres are arranged on a circle around said axis (8).

3. The apparatus according to claim 1 or claim 2, wherein said apparatus (1) is an apparatus (1) for coating a substrate (14), in particular for coating a single substrate (14), with a dielectric coating, in particular an apparatus (1) for reactive magnetron sputtering of metal oxides with pulsed DC sputtering.

4. The apparatus according to one of the preceding claims, comprising high voltage switching elements, wherein said a power supply (15) is connected to said targets (11,12) via said high voltage switching elements for allowing said targets (11,12) to operate alternatively as cathode and anode.

5. The apparatus according to one of the preceding claims, wherein said power supply (15) is a single power supply (15) connected to said targets (11,12), in particular a single DC power supply (15).

6. The apparatus according to one of the preceding claims, wherein said targets (11,12) are circular targets.

7. A method for manufacturing a coated substrate (14) by coating a substrate (14) by reactive sputtering in an apparatus (1) comprising an axis (8), said method comprising the steps of
a) providing a substrate (14) to be coated;
b) providing at least two targets (11,12) in an arrangement symmetrically to said axis (8), said targets (11,12) bering arranged such that a plane defined by an unsputtered front plane of the respective target (11; 12) is angled between 2° and 20° with respect to a plane perpendicular to said axis (8);
c) alternatively operating said targets (11,12) as cathode and anode during coating; and
d) rotating said substrate (14) around said axis (8) during said coating.

8. The method according to claim 7, wherein said arrangement symmetrically to said axis comprises that said targets (11,12) are arranged with their respective target centres on a defined radius around said axis (8) .

9. The method according to claim 7 or claim 8, comprising the step of coating said substrate (14), in particular a single substrate (14), with a dielectric coating, in particular coating said substrate (14), in particular a single substrate (14), by reactive magnetron sputtering of metal oxide with pulsed DC sputtering.

10. The method according to one of claims 7 to 9, wherein step c) comprises using high voltage switching elements connected to said targets (11,_12) and to a power supply (15) for alternatively operating said targets (11,12) as cathode and anode during coating, in particular wherein said power supply (15) is a single power supply (15), more particularly a single DC power supply (15).

11. The method according to one of claims 7 to 10, wherein said coating is accomplished by constant voltage sputtering.

12. The method according to one of claims 7 to 11, wherein step c) comprises applying a target voltage to said targets (11,12), and wherein the method comprises the step of adjusting the pulse width of said target voltage for fine-tuning the thickness of the manufactured coating in the inner and outer region of the substrate.

13. The method according to one of claims 7 to 12, wherein said targets (11, 12) are alternatively operated as cathode and anode at a frequency of 40 kHz.

14. The method according to one of claims 7 to 13, wherein said targets (11, 12) are circular targets.

15. The method according to one of claims 7 to 14, wherein a coating manufactured by said method comprises at least one of the group consisting of
- a low absorption film;
- an optical dielectric filter;
- a wave guide;
- an optical thin film;
- an Al₂O₃ film;
- a Ta₂O₅ film, in particular a Ta₂O₅ film sandwiched between SiO₂ or Al₂O₃ cladding layers;
- a film of mixed oxides, in particular from metallic targets of different composition.

## Patentansprüche

1. Vorrichtung (1) zum Beschichten eines Substrats (14) durch reaktives Sputtern, umfassend eine Achse (8), wenigstens zwei Targets (11, 12) in einer Anordnung symmetrisch zu der Achse (8), einen Substratträger (5) zum Tragen des Substrats (14) und eine mit den Targets (11, 12) verbundene Energieversorgung (15), wobei die Targets alternativ als Kathode und Anode betreibbar sind, **dadurch gekennzeichnet, dass** die Vorrichtung (1) ferner Mittel zum Drehen des Substratträgers (5) um die Achse (8) umfasst, und ferner **dadurch gekennzeichnet, dass** die Targets (11, 12) derart angeordnet sind, dass eine Ebene, die durch eine nicht gesputterte vordere Ebene des jeweiligen Targets (11; 12) definiert wird, in Bezug auf eine Ebene senkrecht zu der Achse (8) zwischen 2° und 20° abgewinkelt ist.

2. Vorrichtung nach Anspruch 1, wobei die Anordnung symmetrisch zu der Achse (8) umfasst, dass die Targets (11, 12) derart angeordnet sind, dass ihre jeweiligen Target-Mittelpunkte auf einem Kreis um die Achse (8) angeordnet sind.

3. Vorrichtung nach Anspruch 1 oder Anspruch 2, wobei die Vorrichtung (1) eine Vorrichtung (1) zum Beschichten eines Substrats (14), insbesondere zum Beschichten eines einzigen Substrats (14), mit einer dielektrischen Beschichtung ist, insbesondere eine Vorrichtung (1) zum reaktiven Magnetronsputtern von Metalloxiden mit gepulstem Gleichstromsputtern.

4. Vorrichtung nach einem der vorhergehenden Ansprüche, umfassend Hochspannungs-Schaltelemente, wobei die Energieversorgung (15) über die Hochspannungs-Schaltelemente mit den Targets (11, 12) verbunden ist, um es den Targets (11, 12) zu ermöglichen, alternativ als Kathode und Anode betrieben zu werden.

5. Vorrichtung nach einem der vorhergehenden Ansprüche, wobei die Energieversorgung (15) eine einzige Energieversorgung (15) ist, die mit den Targets (11, 12) verbunden ist, insbesondere eine einzige Gleichstrom-Energieversorgung (15).

6. Vorrichtung nach einem der vorhergehenden Ansprüche, wobei die Targets (11, 12) kreisförmige Targets sind.

7. Verfahren zur Herstellung eines beschichteten Substrats (14) durch Beschichten eines Substrats (14) mittels reaktiven Sputterns in einer Vorrichtung (1), die eine Achse (8) umfasst, wobei das Verfahren die folgenden Schritte umfasst:
a) Bereitstellen eines zu beschichtenden Substrats (14);
b) Bereitstellen von wenigstens zwei Targets (11, 12) in einer Anordnung symmetrisch zu der Achse (8), wobei die Targets (11, 12) derart angeordnet sind, dass eine Ebene, die durch eine nicht gesputterte vordere Ebene des jeweiligen Targets (11; 12) definiert wird, in Bezug auf eine Ebene senkrecht zu der Achse (8) zwischen 2° und 20° abgewinkelt ist;
c) alternatives Betreiben der Targets (11, 12) als Kathode und Anode während des Beschichtens; und
d) Drehen des Substrats (14) um die Achse (8) während des Beschichtens.

8. Verfahren nach Anspruch 7, wobei die Anordnung symmetrisch zu der Achse umfasst, dass die Targets (11, 12) mit ihren jeweiligen Target-Mittelpunkten auf einem definierten Radius um die Achse (8) angeordnet sind.

9. Verfahren nach Anspruch 7 oder Anspruch 8, umfassend den Schritt des Beschichtens des Substrats (14), insbesondere eines einzigen Substrats (14), mit einer dielektrischen Beschichtung, insbesondere des Beschichtens des Substrats (14), insbesondere eines einzigen Substrats (14), durch reaktives Magnetronsputtern von Metalloxid mit gepulstem Gleichstromsputtern.

10. Vorrichtung nach einem der Ansprüche 7 bis 9, wobei der Schritt c) das Verwenden von Hochspannungs-Schaltelementen umfasst, die mit den Targets (11, 12) und mit einer Energieversorgung (15) verbunden sind, um die Targets (11, 12) während des Beschichtens alternativ als Kathode und Anode zu betreiben, wobei die Energieversorgung (15) insbesondere eine einzige Energieversorgung (15), vor allem eine einzige Gleichstrom-Energieversorgung (15) ist.

11. Verfahren nach einem der Ansprüche 7 bis 10, wobei das Beschichten durch Konstantspannungssputtern erfolgt.

12. Verfahren nach einem der Ansprüche 7 bis 11, wobei der Schritt c) das Anlegen einer Target-Spannung an die Targets (11, 12) umfasst und wobei das Verfahren den Schritt des Einstellens der Impulsbreite der Target-Spannung zur Feineinstellung der Dicke der hergestellten Beschichtung im inneren und äußeren Bereich des Substrats umfasst.

13. Verfahren nach einem der Ansprüche 7 bis 12, wobei die Targets (11, 12) alternativ als Kathode und Anode mit einer Frequenz von 40 kHz betrieben werden.

14. Verfahren nach einem der Ansprüche 7 bis 13, wobei die Targets (11, 12) kreisförmige Targets sind.

15. Verfahren nach einem der Ansprüche 7 bis 14, wobei eine durch das Verfahren hergestellte Beschichtung wenigstens eines aus der Gruppe umfasst, die aus Folgendem besteht:
- einem Film mit geringer Absorption;
- einem optischen dielektrischen Filter;
- einem Wellenleiter;
- einem optischen Dünnfilm;
- einem Al₂O₃-Film;
- einem Ta₂O₅-Film, insbesondere einem Ta₂O₅-Film, der sandwichartig zwischen SiO₂- oder Al₂O₃-Deckschichten angeordnet ist;
- einem Film aus gemischten Oxiden, insbesondere aus metallischen Targets von unterschiedlicher Zusammensetzung.

## Revendications

1. Appareil (1) pour revêtir un substrat (14) par pulvérisation réactive, comprenant un axe (8), au moins deux cibles (11, 12) dans un agencement symétrique audit axe (8), un substrat porteur (5) pour porter ledit substrat (14) et une alimentation électrique (15) raccordée auxdites cibles (11, 12), dans lequel lesdites cibles peuvent fonctionner alternativement en cathode et anode, **caractérisé en ce que** l'appareil (1) comprend en outre des moyens pour faire tourner ledit substrat porteur (5) autour dudit axe (8), et **caractérisé en outre en ce que** lesdites cibles (11, 12) sont disposées de sorte que le plan défini par le plan avant non pulvérisé de la cible respective (11, 12) forme un angle compris entre 2° et 20° par rapport au plan perpendiculaire audit axe (8).

2. Appareil selon la revendication 1, dans lequel ledit agencement symétrique audit axe (8) consiste en ce que lesdites cibles (11, 12) soient disposées de telle façon que leurs centres cibles respectifs soient disposés sur un cercle autour dudit axe (8).

3. Appareil selon la revendication 1 ou 2, dans lequel ledit appareil (1) est un appareil (1) pour revêtir un substrat (14), en particulier pour revêtir un substrat unique (14), avec un revêtement diélectrique, en particulier un appareil (1) pour une pulvérisation réactive au magnétron d'oxydes de métal avec une pulvérisation DC pulsée.

4. Appareil selon l'une des revendications précédentes, comprenant des éléments de commutation haute tension, dans lequel ladite alimentation électrique (15) est raccordée auxdites cibles (11, 12) via lesdits éléments de commutation haute tension pour permettre auxdites cibles (11, 12) de fonctionner alternativement en cathode et anode.

5. Appareil selon l'une des revendications précédentes, dans lequel ladite alimentation électrique (15) est une alimentation électrique unique (15) raccordée auxdites cibles (11, 12), en particulier une alimentation électrique DC unique (15).

6. Appareil selon l'une des revendications précédentes, dans lequel lesdites cibles (11, 12) sont des cibles circulaires.

7. Procédé pour fabriquer un substrat revêtu (14) en revêtant un substrat (14) par pulvérisation réactive dans un appareil (1) comprenant un axe (8), ledit procédé comprenant les étapes consistant à :
a) fournir un substrat (14) à revêtir ;
b) fournir au moins deux cibles (11, 12) dans un agencement symétrique audit axe (8), lesdites cibles (11, 12) étant disposées de sorte que le plan défini par le plan avant non pulvérisé de la cible respective (11, 12) forme un angle compris entre 2° et 20° par rapport au plan perpendiculaire audit axe (8) ;
c) faire fonctionner alternativement lesdites cibles (11, 12) en cathode et anode pendant le revêtement ; et
d) faire tourner ledit substrat (14) autour dudit axe (8) pendant ledit revêtement.

8. Procédé selon la revendication 7, dans lequel ledit agencement symétrique audit axe consiste en ce que lesdites cibles (11, 12) soient disposées avec leurs centres cibles respectifs sur un rayon défini autour dudit axe (8).

9. Procédé selon la revendication 7 ou 8, comprenant l'étape consistant à revêtir ledit substrat (14), en particulier un substrat unique (14), avec un revêtement diélectrique, en particulier à revêtir ledit substrat (14), en particulier un substrat unique (14), par pulvérisation réactive au magnétron d'oxyde de métal avec une pulvérisation DC pulsée.

10. Procédé selon l'une des revendications 7 à 9, dans lequel l'étape c) consiste à utiliser des éléments de commutation haute tension raccordés auxdites cibles (11, 12) et à une alimentation électrique (15) pour faire fonctionner alternativement lesdites cibles (11, 12) en cathode et anode pendant le revêtement, en particulier dans lequel ladite alimentation électrique (15) est une alimentation électrique unique (15), plus particulièrement une alimentation électrique DC unique (15).

11. Procédé selon l'une des revendications 7 à 10, dans lequel ledit revêtement est réalisé par pulvérisation à tension constante.

12. Procédé selon l'une des revendications 7 à 11, dans lequel l'étape c) consiste à appliquer une tension cible auxdites cibles (11, 12) et dans lequel le procédé comprend l'étape consistant à ajuster la largeur d'impulsion de ladite tension cible pour peaufiner l'épaisseur du revêtement réalisé dans la région intérieure et extérieure du substrat.

13. Procédé selon l'une des revendications 7 à 12, dans lequel lesdites cibles (11, 12) fonctionnent alternativement en cathode et anode à une fréquence de 40 kHz.

14. Procédé selon l'une des revendications 7 à 13, dans lequel lesdites cibles (11,12) sont des cibles circulaires.

15. Procédé selon l'une des revendications 7 à 14, dans lequel le revêtement fabriqué par ledit procédé comprend au moins un élément du groupe composé de
- un faible film d'absorption ;
- un filtre optique diélectrique ;
- un guide d'onde ;
- un film fin optique ;
- un film Al₂O₃ ;
- un film Ta₂O₅, en particulier un film Ta₂O₅ pris en sandwich entre des couches de placage SiO₂ ou Al₂O₃ ;
- un film d'oxydes mixtes, en particulier de cibles métalliques de composition différente.
